# EUROPEAN PATENT APPLICATION

(11) **EP 2 366 978 A2**
(43) Date of publication of application: **21.09.2011**
(21) Application number: 11152921.0
(22) Date of filing: 01.02.2011
(51) Int. Cl.: G01D 11/24

(54) **Cable leading-out structure**

(30) Priority: 15.03.2010 JP 2010057681
(71) Applicant: Yamatake Corporation, Tokyo 100-6419 (JP)
(72) Inventor: Mizobuchi, Manabu, Chiyoda-ku Tokyo 100-6419 (JP); Suzuki, Hisashi, Chiyoda-ku Tokyo 100-6419 (JP)
(74) Representative: Tomlinson, Kerry John

(57) **Abstract**

There is provided a cable leading-out structure. The structure includes: a housing (6) that houses a circuit board (4) and has an opening (7) therein. A cable (5) connected to the circuit board is led from the inside of the housing to the outside through the opening, and the housing (6) comprises: an elastic member (21) provided around the opening.

## Description

### Technical Field

The present disclosure relates to a cable leading-out structure for leading out a cable connected to a circuit board of an electronic device such as a photoelectric sensor from a housing that houses the circuit board.

### Related Art

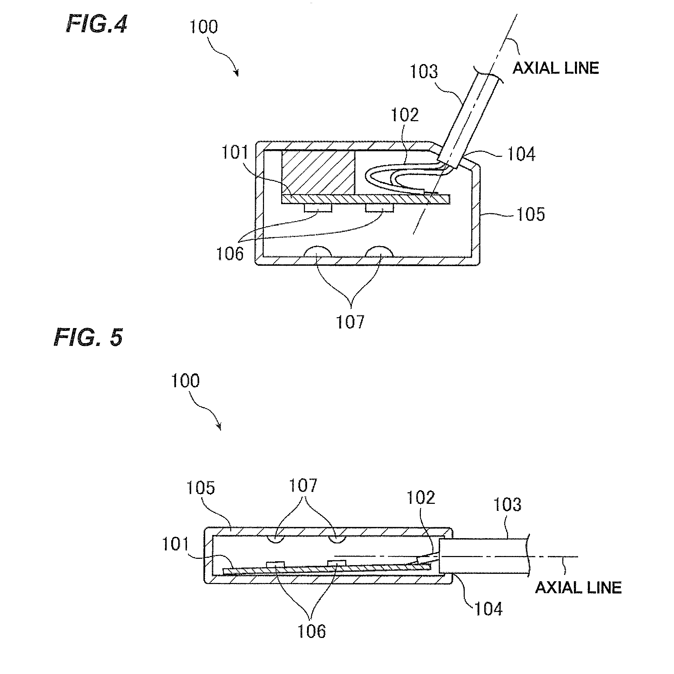

As shown in Fig. 4, in a related-art photoelectric sensor 100 having a general use size, a printed circuit board 101 is housed in a housing 105 having lenses 107 in such a manner that the printed circuit board 101 is fixed to the housing 105 by such a means as screwing or bonding. And a cable 103 having core wires 102 that are connected to the printed circuit board 101 is led out through an opening 104. Where the photoelectric sensor 100 is designed without paying much attention to miniaturization, it is relatively easy to form an excess space in the housing 105 (*see* JP-A-7-226135, for example).

In this case, even in the case where the axial line of the opening 104 cannot be in the same plane as the surface of the printed circuit board 101, even when external force is applied to the cable 103 or portions, exposed from the cable 103, of the core wires 102, resulting tension is eased through deformation the exposed portions of the core wires 102 if the exposed portions of the core wires 102 are given great lengths and caused to wind their way inside the housing 105. That is, the printed circuit board 101 is prevented from receiving excessive stress by causing the exposed portions of the core wires 102 to serve as buffer members. As a result, the printed circuit board 101 suffers no positional deviation and the accuracy of positioning between optical elements 106 mounted on the printed circuit board 101 and the respective lenses 107 mounted on the housing 105 is not lowered.

However, as the degree of miniaturization of the photoelectric sensor 100 is increased, it becomes difficult to secure a sufficient space for the exposed portions of the core wires 102 to wind their way inside the housing 105. Where as shown in Fig. 5 the axial line of the opening 104 cannot be in the same plane as the surface of the printed circuit board 101, tension that is caused by external force that, for example, bends, straightens, or pulling in the axial direction the cable 103 produces stress that acts on the printed circuit board 101 via the exposed portions of the core wires 102 which are connected to the printed circuit board 101. For another example, when work of connecting end portions, on the side opposite to the side of the connection to the printed circuit board 101, of the core wires 102 to another device (not shown) is performed, if external force is exerted on the end portions of the core wires 102, the core wires 102 are deviated in the axial direction in the cable 103 and, at the same time, stress is transmitted to the printed circuit board 101 which is connected to the core wires 102 and produces force of lifting up the printed circuit board 101. In either case, the printed circuit board 101 may suffer a positional deviation. In that event, the optical elements also suffer positional deviations, resulting in reduction in the accuracy of positioning between the optical elements 106 and the respective lenses 107.

One countermeasure would be to shift the position of the opening 104 so that it is located in a lower portion of the housing 105. However, where the photoelectric sensor 100 is small, the cable diameter is large relative to the housing 105. And the bottom of the opening 104 cannot be lowered beyond the top surface of the bottom plate of the housing 105. Therefore, the influence of tension transmitted by the cable 103 or the core wires 102 cannot be eliminated.
Furthermore, where the cable 103 is a triple-core cable having three core wires 102, tension transmitted by the cable 103 or the core wires 102 is higher and hence the printed circuit board 101 is more prone to a positional deviation.

### SUMMARY

It is an illustrative aspect of the present invention to provide a cable leading-out structure for an electronic device which can lower the degree of positional deviation of a printed circuit board caused by tension transmitted by a cable or core wires and thereby miniaturize the electronic device even in the case where the axial line of an opening of a housing cannot be in the same plane as the surface of the printed circuit board.

According to one or more illustrative aspects of the present invention, there is provided a cable leading-out structure. The structure includes: a housing that houses a circuit board and has an opening therein. A cable connected to the circuit board is led from the inside of the housing to the outside through the opening, and the housing comprises: an elastic member provided around the opening.

In the invention, the circuit-board-side portion, adjacent to the opening, of the housing is elastically deformable. Therefore, even where the axial line of the opening cannot be in the same plane as the surface of the circuit board, the axial line of the cable can be set close to the surface of the printed circuit board because the circuit-board-side portion, adjacent to the opening, of the housing is elastically deformed. As a result, the degree of positional deviation of the printed circuit board that is caused by tension transmitted by the cable or its core wires can be lowered and an electronic device which employs the cable leading-out structure can be miniaturized.

### BRIEF DESCRIPTION OF THE DRAWING

Fig. 1 is a sectional view showing the configuration of a photoelectric sensor according to a first embodiment of the present invention;
Figs. 2A and 2B show the structure of an opening of the photoelectric sensor according to the first embodiment of the invention; Figs. 2A and 2B are side views showing states with no cable and with a cable 5, respectively;
Fig. 3 is a sectional view showing the structure of a cable used in a second embodiment of the invention;
Fig. 4 is a sectional view showing the configuration of a photoelectric sensor in the related art; and
Fig. 5 is a sectional view showing the configuration of another photoelectric sensor in the related art.

### DETAILED DESCRIPTION OF EXEMPLARY EMBODIMENTS

Photoelectric sensors as electronic devices according to embodiments of the present invention will be hereinafter described in detail with reference to the drawings.

### First embodiment

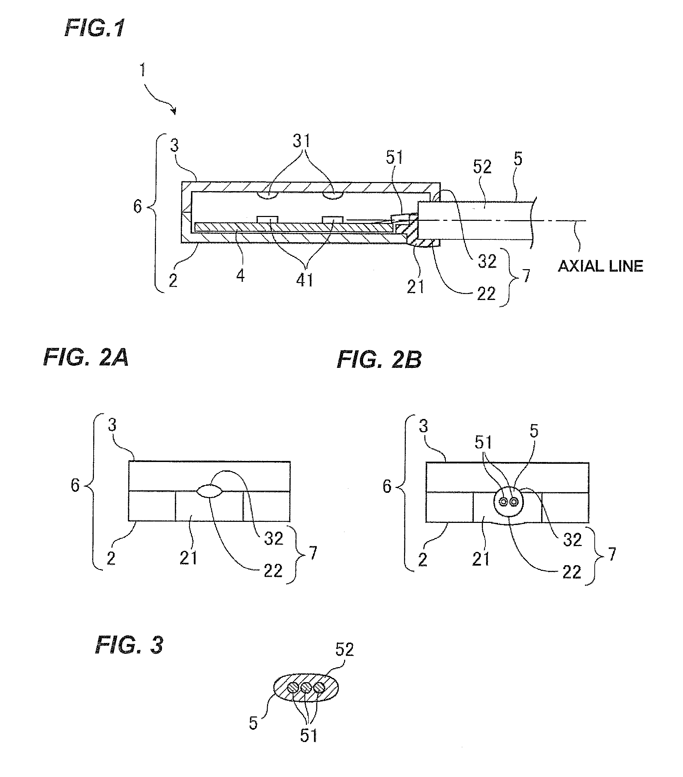

Fig. 1 is a sectional view showing the configuration of a photoelectric sensor 1 according to a first embodiment of the invention. Figs. 2A and 2B show the structure of an opening 7 of the photoelectric sensor 1 according to the first embodiment of the invention; Figs. 2A and 2B are side views showing states with no cable and with a cable 5, respectively. As shown in Fig. 1 and Figs. 2A and 2B, the photoelectric sensor 1 is composed of a case 2, a cover 3, a printed circuit board 4, and the cable 5.

The case 2, which is a member for fixing and housing of the printed circuit board 4, is made of resin and has an open-top box shape. An elastic member 21 is formed on one sideline of the case 2. When the cable 5 is placed on the elastic member 21 and the cover 3 is attached to the case 2, the elastic member 21 is elastically deformed being pressed by the cable 5 toward the bottom of the case 2. The elastic member 21 is made of an elastic material that is softer than a sheath 52 of the cable 5, such as rubber or elastomer. In general, the sheath 52 of the cable 5 is also made of an elastic material (first elastic material) such as rubber or elastomer. The elastic member 21 is made of a second elastic material having a smaller elastic modulus than the first elastic material. The top surface of the elastic member 21 is formed with a groove 22 for holding the cable 5 by putting it between itself and the cover 3 when the cable 5 is placed on it and the cover 3 is attached to the case 2. The groove 22 is shallow relative to the thickness of the cable 5.

When the cover 3 is attached to the case 2, they are integrated into a housing 6. The cover 3 is made of resin and has an open-bottom box shape. Lenses 31 are attached to the cover 3. A groove 32 is formed in the cover 3 at such a position as to be opposed to the groove 22. When the cover 3 is attached to the case 2, the grooves 22 and 23 are integrated into the opening 7 for holding the cable 5 by putting it between the grooves 22 and 23.

Mounted with optical elements 41, the printed circuit board 4 is fixed to the case 2 after being positioned so that the optical elements 41 are located at prescribed positions that are suitable for the positions of the lenses 31, respectively.
The cable 5 is composed of two core wires 51 and a protective sheath 52 which covers the two core wires 51. One ends of the core wires 51 are connected to the printed circuit board 4. The cable 5 is led out of the housing 6 in a state that the cable 5 is held by the opening 7.

Next, a description will be made of how the above-configured photoelectric sensor 1 is assembled.
To assemble the photoelectric sensor 1, first, the printed circuit board 4 is fixed to the case 2 at a prescribed position inside the case 2. Then, the core wires 51 of the cable 5 are connected to the printed circuit board 4 and the cable 5 is placed on the groove 22 of the elastic member 21. Alternatively, the printed circuit board 4 is fixed to the case 2 at a prescribed position inside the case 2 after the core wires 51 of the cable 5 are connected to the printed circuit board 4, and the cable 5 is placed on the groove 22 of the elastic member 21.
Then, after the cover 3 is attached to the case 2, the cable 5 is led out of the housing 6 in a state that the cable 5 is held by the opening 7.

At this step, the cable 5 is pressed by the hard cover 3 toward the bottom of the case 2 (i.e., downward in Fig. 1) and the elastic member 21 is pressed by the cable 5 toward the bottom of the case 2. Since the elastic member 21 is made of a material that has a smaller elastic modulus than the cable 5, in other words, is more apt to be deformed elastically, the pressing force elastically deforms the elastic member 21 much more than the case 2, the cover 3, and the cable 5 and thereby moves the cable 5 toward the bottom of the case 2. Therefore, part of the cable 5 can be located under the top surface of the bottom plate of the case 2, whereby the axial line of the cable 5 can be set close to the surface of the printed circuit board 4. This reduces force acting on the printed circuit board 4 in the direction that it goes away from the cover 3, the force being caused by tension transmitted by the core wires 51, whereby the degree of positional deviation of the printed circuit board 4 can be lowered. As a result, reduction in the accuracy of positioning between the optical elements 106 and the respective lenses 107 can be suppressed.

When the photoelectric sensor 1 has been assembled, a bottom portion of the elastically deformed elastic member 21 projects from the back surface of the case 2. However, when the photoelectric sensor 1 is attached to an attachment surface when it is used, the projected portion of the elastic member 21 is deformed elastically being pressed inward by the attachment surface. Therefore, the photoelectric sensor 1 can be used in the same manner as conventional ones.

As described above, in the first embodiment, the top surface of the elastic member 21 which can be deformed elastically is formed with the groove 22. Therefore, even where the axial line of the opening 7 cannot be in the same plane as the surface of the printed circuit board 4, the axial line of the cable 5 can be set close to the surface of the printed circuit board 4. As a result, the degree of positional deviation of the printed circuit board 4 that is caused by tension transmitted by the cable 5 or the core wires 51 can be lowered and the photoelectric sensor 1 can be miniaturized.

Since the opening 7 is formed in the side wall of the housing 6 so that the cable 5 can be oriented parallel with the surface of the printed circuit board 4, the axial line of the cable 5 can be set close to the surface of the printed circuit board 4.

Although in the first embodiment the top surface of the elastic member 21 which can be deformed elastically is formed with the groove 22, a modification is possible in which an elastic member 21 which can be deformed elastically is also formed in the cover 3 and the bottom surface of that elastic member is formed with a groove 32. With this configuration, where the cable 5 is a triple-core cable having three core wires 51, influence of tension transmitted by the core wire 51 that is most distant from the surface of the printed circuit board 4 can be suppressed further.

### Second embodiment

In the first embodiment, the top surface of the elastic member 21 which can be deformed elastically is formed with the groove 22 so that the axial line of the cable 5 can be set close to the surface of the printed circuit board 4. On the other hand, in the second embodiment, where the cable 5 is a triple-core cable, as shown in Fig. 3 the core wires 51 are arranged in the same plane (flat arrangement).
The use of the flat triple-core cable also makes it possible to set the axial lines of the respective core wires 51 of the cable 5 close to the surface of the printed circuit board 4. As a result, the degree of positional deviation of the printed circuit board 4 that is caused by tension transmitted by the cable 5 or each core wire 51 can be lowered and the photoelectric sensor 1 can be miniaturized.

Although the second embodiment is directed to the case of using the flat triple-core cable, the invention is not limited to such a case. A flat arrangement may also be employed in a quadruple-core cable having four core wires 51.

Although the first and second embodiments are directed to the photoelectric sensor 1 as an electronic device, the invention is not limited to such a case. The invention can likewise be applied to other electronic devices in which the accuracy of positioning of a printed circuit board to which a cable is connected is required to be high.

## Claims

1. A cable leading-out structure comprising:
a housing (6) that houses a circuit board (4) and has an opening (7) therein, wherein a cable (5) connected to the circuit board is led from the inside of the housing to the outside through the opening,
wherein the housing (6) comprises: an elastic member (21) provided around the opening.

2. The structure of claim **1,** wherein the opening (7) is formed in the housing (6) such that the cable (5) is in parallel with a surface of the circuit board.

3. The structure of claim **2,** wherein the cable (5) is in parallel with the surface of the circuit board by elastic deformation of the elastic member (21) contacting the cable (5).

4. The structure of claim **1** to **3,** wherein
the housing (6) further comprises: a case (2) and a cover (3) covering the case (2),
the circuit board (4) is disposed on the case (2),
the elastic member (21) is sandwiched by the case (2), and
the opening (7) is formed between the elastic member (21) and the cover (3).
